Europäisches Patentamt

European Patent Office

Office européen des brevets

(19)

(11) **EP 1 246 199 A2**

(12) ## EUROPEAN PATENT APPLICATION

(43) Date of publication:
**02.10.2002 Bulletin 2002/40**

(51) Int Cl.7: **G11C 27/02**, H03M 3/02

(21) Application number: **02003497.1**

(22) Date of filing: **15.02.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **30.03.2001 IT MI010679**

(71) Applicant: **Siemens Information and Communication Networks S.p.A.**
**20126 Milano (IT)**

(72) Inventors:
• **Gatti, Umberto**
  **27100 Pavia (IT)**

• **Malcovati, Piero**
  **27100 Pavia (IT)**
• **Maloberti, Franco**
  **27020 Torre d'Isola (IT)**

(74) Representative: **Giustini, Delio**
  **Siemens Information and Communication Networks S.p.A.**
  **Palazzo Gorky**
  **Via Monfalcone, 1**
  **20092 Cinisello Balsamo (IT)**

(54) **Bipolar junction transistor charge transfer network**

(57) Charge transfer network from a sampling capacitor ($C_1$) to an integration capacitor ($C_2$) consisting of two identical structures, made of a first branch and a second branch connected in parallel between a first node and a second node, respectively connected to the supply nodes through bias current generators, each branch consisting of a couple of switches in series, the sampling capacitor ($C_1$) being connected to a current common node (A) of the switches of the first branch of both the structures and the integration capacitor ($C_2$) being connected to the first node of the first structure, being the current common nodes (B) of the switches of the second branch of both the structures connected between them, the control signals of the switched of the first and second branches being cross-coupled to two control phases ($\Phi_1$, $\Phi_2$). The charge transfer network is used in the implementation of switched-capacitors integrators of *sigma-delta* converters (Fig. 6a).

Fig. 6a

EP 1 246 199 A2

**Description**

FIELD OF THE INVENTION

The present invention relates to the conversion of electrical signals into the digital form and more in particular a bipolar junction transistor charge transfer network that can be integrated in a switched-capacitors integrator circuit and in *sigma-delta* converters.

BACKGROUND ART

The present applications in the field of electronic instrumentation and telecommunications require integrated analogue-to-digital converters (ADC) having increasingly higher operation speed, and requiring at the same time exceptional performances in terms of linearity and resolution. For instance, the specifications of the ADCs employed in the receiving section of broad band transceiver stations (BTS), based on the GSM/DCS1800 and UMTS standards, foresee a minimum sampling frequency of 65 MHz, a resolution higher than 12 bits and an SFDR (Spurious Free Dynamic Range) higher than 80 dBFS.

There are many factors that limit the performances that can be reached by said converters, from among which a more significant one is represented by the impossibility to implement integrated switches (*switches*) conjugating linearity and speed, though in presence of technologies characterized by limited costs.

It is here briefly described the known art relevant to the implementation of an integrated switch and of analogue-to digital *sigma-delta* converters.

INTEGRATED SWITCHES

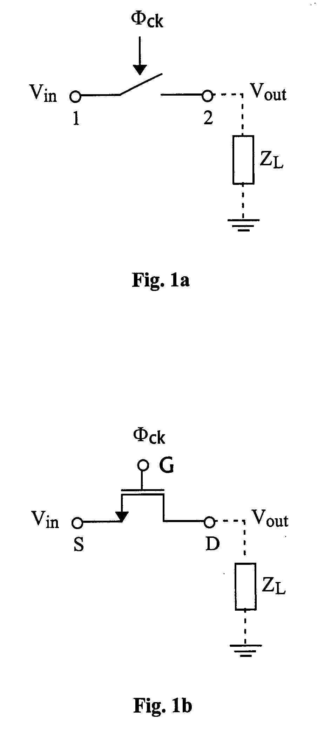

Figure 1a shows the switch symbol. As it is already known, it ideally behaves as a short circuit in the ON state and in an open circuit in the OFF state. A switch is used to transfer a charge from a node to another node and fix a voltage on a high impedance node. Essential performances of an integrated switch (see [1] S. K. Tewksbury et al., "Terminology Related to the Performance of S/H, A/D and D/A Circuits", IEEE Transactions on Circuits and Systems, Vol. CAS-25, pages 419-426, July 1978) are:

- Difference in voltage between node 1 and node 2 when the switch is in ON state;
- Voltage error introduced on node 2 during the opening phase (OFF);
- Maximum switching speed between the two states (ON to OFF and vice versa).

Concerning the first point, after a possible transient during the closing phase, the current in the switch goes to zero if node 2 shows high impedance. In the contrary instance, a voltage difference proportional to the non-null value of the resistance between the two terminals can be generated between node 1 and node 2.

The opening phase of a switch, can involve an alteration of the voltage present on terminal 2. It can be determined either by the injection of a spurious charge $\Delta V_p$ (*pedestal-error*) in 2, or by the coupling between the control signal applied $\Phi_{ck}$, which is a clock signal, and the terminal itself.

The maximum switching speed is limited both by the rapidity according to which the node 2 reaches a voltage value equal to that present on node 1 in the transient from ON to OFF, called acquisition time $\tau_{acq}$ (*acquisition-time*), and by the capacity of the clock $\Phi_{ck}$ to drive the load represented by the switch itself.

The effects described above depend both on the implementation selected for the integrated switch and on the context of the circuit in which it is inserted.

The most common method for the realization of integrated switches, having the characteristics described above, foresees the use of semiconductor devices (transistors) of the MOS (Metal-Oxide Semiconductor) type, as shown in Figure 1b. The application of an adequate driving voltage on the *gate* of the MOS (node G), equal to the positive supply voltage for enhancement N-channel devices (NMOS) and to the negative one for depletion devices, enables the device switching on (vice versa for P-channel devices, PMOS). After an initial transient, the transistor operates in a so called linear mode (*triode region),* characterized by a null $V_{ds}$ voltage, as to behave as low value resistance, placed between the *source* (node S) and the *drain* (node D) terminals.

The implementation of switches according to this method, although comparatively simple, shows some drawbacks that alter its essential performances.

Firstly, the behaviour as equivalent resistance, combined to the presence of a load generally having capacitive nature on terminal 2 of the device, causes the output voltage to increase according to an exponential law with a given time constant, and this can originate an incomplete equality of the voltage on the output node $V_{out}$ compared to the input one $V_{in}$. This phenomenon strictly connects to the maximum switching speed, limiting in practice the maximum control clock frequency that can be used.

Secondly, the switch opening induces an injection in the *drain* terminal by the charge contained in the MOS channel, in a proportion depending on the contouring conditions (see [2] G. Wegmann, E. A; Vittoz, F. Rahali, "Charge Injection in Analog MOS Switches", IEEE Journal of Solid-State Circuits, Vol. SC-22, pages 1091-1097, December 1987).

Furthermore, the presence of *overlap* parasitic capacitances between the *gate* and *drain* nodes induces a coupling with the edges of the clock applied to the *gate* (*clock-feedthrough* phenomenon).

There are different solutions to reduce the problems mentioned above. An approximate expression of the charge injected for a MOS switch with N-channel (faster than a P-channel) is given by:

$$Q_{inj} \approx \frac{1}{2}\left\{WL_{eff}C_{ox}\left|\left(V_{DD} - V_{in} - V_{th}\right)\right|\right\} \tag{1}$$

where W and $L_{eff}$ are the effective length and width of the MOS, $C_{ox}$ the specific capacitance of the silicon oxide, $V_{DD}$ the positive supply voltage, $V_{in}$ the input voltage and $V_{th}$ the MOS threshold voltage. As it can be noticed, $Q_{inj}$ depends on the input signal with the multiplicative constant introduced by the product $WL_{eff}$ of the transistor.

Since the $V_{in}$ signal is a design specification and cannot be changed, a first solution is to use devices having minimum W and $L_{eff}$ size. Unfortunately, W cannot be reduced more than some given value, to have a small equivalent resistance between nodes D and S, as it shall be explained later on.

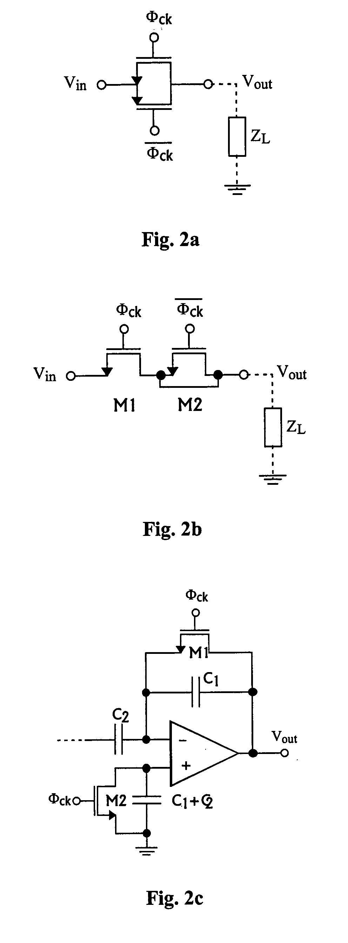

Methods have been proposed to overcome this limit. A first solution, shown in Figure 2a, foresees the use of two complementary MOS devices (PMOS and NMOS), in order to obtain a compensation of the negative charges injected through the injection of positive charges.

A second solution (see [3] C. Eichenberger, W. Guggenbuhl, "Dummy Transistor Compensation of Analog MOS Switches", IEEE Journal of Solid-State Circuits, Vol. SC-24, pages 1143-1145, August 1989), represented in Figure 2b, foresees the use of a second MOS device $M_2$ (called *dummy-switch*) of the same type as the previous one that, having channel width (W/2) equal to one half of the width of channel W of the main switch $M_1$ and a timing in counter phase compared to the main switch, partially absorbs the charge injected by the main switch.

Other possible solutions (see [4] K. Martin, "New clockfeedthrough cancellation technique for analogue MOS switched capacitor," Electronics Letters, no. 18, 1982, [5] D.G. Haigh, B. Singh, "A switching scheme for switched capacitor filters which reduces effect of parasitic capacitances associated with switch control terminals", IEEE International Symposium on Circuits and Systems, Newport, 1983, vol. 2, pp. 586-589 and [6]. D. Johns, K. Martin, "Analog Integrated Circuits Design", J. Wiley & Sons, USA, 1997) strictly depend on the context in which the switch is inserted or are based on a complex timing [6]. As an example, whenever the MOS switch $M_1$ is employed combined with a second switch $M_2$, in parallel to a capacitor having value $C_1+C_2$, as shown in Figure 2c [4], the simultaneous opening of $M_1$ and $M_2$ causes the charge injected on both the positive and negative terminals of the amplifier to behave as a common mode noise and does not affect the actual signal.

Finally, it is evident that the introduction of architectures of the differential type (see [7] K. C. Hsieh et al., "A Low Noise Chopper-Stabilized Differential Switched Capacitor Filter Technique", IEEE Journal of Solid-State Circuits, Vol. SC-16, pages 708-715, December 1981) involves a significant reduction of the charge injection, until the *matching* between the dimensions of the devices in the two branches is assured.

Concerning the limitation of performances in terms of speed of the MOS switches, it must be underlined how an improving in this direction could come only from an advance in technology. The value of the equivalent resistance $R_{ON}$ between the two terminals of a single MOS, is determined by the following expression:

$$R_{ON} = \frac{1}{\mu_N C_{ox}\frac{W}{L_{eff}}\left|\left(V_{DD} - V_{in} - V_{th}\right)\right|} \tag{2}$$

where $\mu_N$ if the mobility of electrons. The $R_{ON}$ value depends on the ratio $W/L_{eff}$ of the device in an inversely proportional manner. Therefore, it is convenient to implement devices with comparatively large W and small $L_{eff}$.

According to a technique for the realization of integrated switches, a single bipolar transistor can be used in a configuration equivalent to that of the MOS devices described above. However, the bipolar transistor shows some drawback, known to those skilled in the art, which make this type of use completely impracticable (see [8] A. Sedra, K. Smith, "Microelectronic Circuits - 3rd Ed.", Saunders College Publishing, USA, 1991).

The circuits performing the switch function find large application in the class of analogue-to-digital converters, implemented according to said technique with *switched-capacitors* (see [9] R. Gregorian, G. Temes, "Analog MOS Integrated Circuits for Signal Processing", J. Wiley & Sons, USA, 1986). This technique stands as an alternative to the *continuous-time* technique (see [10] G. Weinan, J.A. Cherry, W.M. Snelgrove, "A 4 GHz fourth-order SiGe HBT band pass Delta-Sigma modulator", Symposium on VLSI Circuits, 1998, Digest of Technical Papers, page 174-175), compared to which it shows some advantages (see [11] N. Wongkomet, "A Comparison of Continuous-Time and Discrete-Time Sigma-Delta Modulators", M.S. Thesis, University of California at Berkeley, 1996), however known to those skilled in the art. In the frame of analogue-to-digital converters for high speed and linearity applications, the so-called *sigma-delta* architecture, thanks to its intrinsic characteristics, represents one of the best compromises of speed, resolution, flexibility and is therefore largely employed in the telecommunication field.

ANALOGUE-TO-DIGITAL *SIGMA-DELTA* CONVERTERS

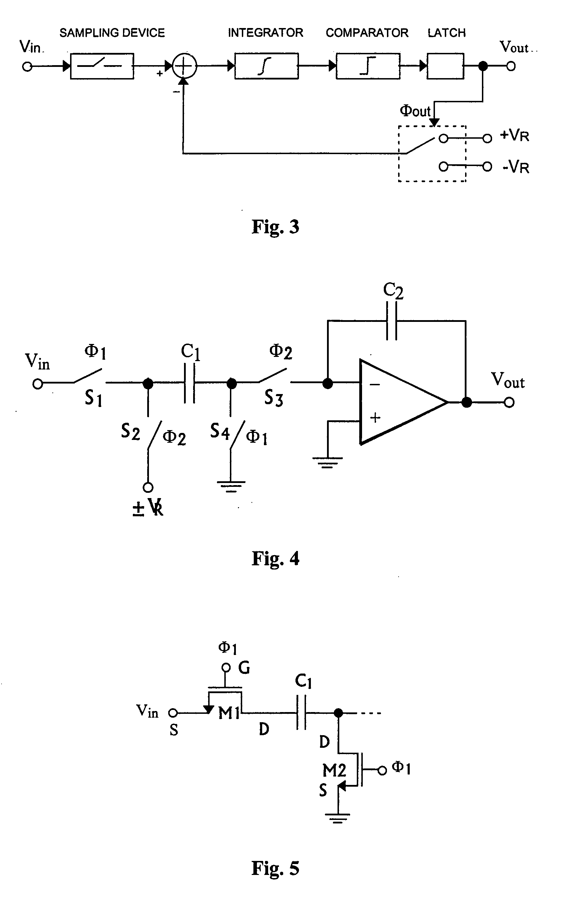

A general diagram of a *sigma-delta* converter (or *delta-sigma* or $\Sigma\Delta$) is shown in Figure 3. The blocks forming a *sigma-delta* of the first order (see [12] S. Norsworthy, R. Schreirer, G. Temes, "Delta-Sigma Data Converters - Theory, Design and Simulation", IEEE Press, NJ, USA, 1997) are an input sampling stage, an integrator, a comparator with latch (1-bit ADC, quantizer) and a 1 bit DAC (represented with a *switch* and reference voltages $\pm V_R$). As it is well known, the same structure can be extended also to multi-bit solutions.

The *sigma-delta* converter is an over-sampling converter, that is, it samples the input signal at a frequency higher than the Nyquist one. Moreover, the feedback structure of Figure 3 allows shifting the quantization noise, introduced by the comparator, out of the signal band. This last effect, called *noise shaping,* makes the signal transfer function (STF) different from that of the quantization noise (NTF). The combined effect of over-sampling and *noise shaping* enables to obtain high resolutions with reasonable clock frequencies. The integrator provides the necessary transfer function to obtain the desired STF and NTF.

The integrator can be implemented with topology of *switched-capacitors* type, as shown in Figure 4. As it can be noticed, the integrator, in *single-ended* configuration, consists of an operational amplifier, two capacitors $C_1$ and $C_2$ and a set of ideal switches controlled by two complementary phases $\Phi_1$ and $\Phi_2$. Its operation can be summarized as follows: during the phase $\Phi_1$ the input signal is sampled on the sampling capacitor $C_1$, while during phase $\Phi_2$ the charge stored in $C_1$ is transferred to the integration capacitor $C_2$, which is in feedback to the operational amplifier.

Letting for simplicity $+V_R = -V_R = 0$, the discrete transform of the transfer function of the circuit shown in Figure 4 is

$$\frac{V(z)_{out}}{V(z)_{in}} = -\frac{C_1}{C_2}\frac{1}{z-1} \tag{3}$$

The expression (3) corresponds to an integration function in the dominion of the Laplace transform, considering the known Forward-Euler transformation.

As it shall be clear to the field specialists, it is necessary that switches can operate at high frequency to obtain performances compatible with the applications indicated above. Up to now, it has been possible to implement the *switches* only through use of transistors MOS (Fig. 1b), with the limits already described.

As already said, the implementation of a switch by means MOS devices involves the presence of limits in the essential performances. Using a single transistor, basing both on Eqn. (1) and on Eqn. (2) it results that, to obtain reduced injection errors and high operation speeds, it is necessary to operate with low values of effective length $L_{eff}$. The latter is limited by the minimum channel length determined by lithographic processes of the technology employed.

Analytically, a Q-factor can be defined, $F_M$, defined as (see [13] B. Razavi, "Principles of Data Conversion System Design", IEEE Press, Piscataway, NJ, USA, 1995):

$$F_M = \frac{1}{\Delta V_p \cdot \tau_{acq}} \tag{4}$$

Remembering that $\Delta V_p = Q_{inj}/C_1$ and $\tau_{acq} = R_{ON}C_1$, we obtain:

$$F_M = \frac{2\mu_N}{L_{eff}^2} \tag{5}$$

From Eqn. (5) it is clear the need to employ the most advanced CMOS technologies foreseeing the integration of transistors with highly sub-micrometric channel (effective width $L_{eff} < 0.20$ μm), which in principle would allow to implement switches having the characteristics described above. However, they show manufacturing costs of the masks 1,5 to 2 times higher than those of mixed analogue technologies bipolar-CMOS (BiCMOS), less advanced from the point of view of the minimum size of the devices. Moreover, the restricted portion of logic generally requested by the ADC does not justify the use of CMOS processes with very reduced physical geometries.

The $F_M$ factor additionally degrades if we consider also the clock-coupling phenomenon, not depending on the input signal, here neglected for simplicity.

The known solutions only partially solve these problems. In fact, the compensation of the charge injection through complementary devices or *dummy-switches* assures only a reduction of the phenomenon. In the first case, considering that $Q_{inj}$ depends on $|(V_{DD} - V_{in} - V_{th})|$ and that $V_{in}$ can assume arbitrary values, the amounts of positive and negative charges injected are not necessarily the same and therefore, do not completely cancel. In the second instance, the complete compensation is based on the assumption that the fraction of charge injected by $M_1$ towards the *drain* is equal to 1/2. This is not always true, but it depends also on the load present on the terminals and on the slope of the clock edge.

Also in differential structures the compensation is only partial and does not assure a satisfactory immunity from *pedestal error*. In fact, input signals have equal module but opposed polarity: since $Q_{inj}$ depends on $V_{in}$, the charges injected by the two branches are not perfectly equal and, therefore, they do not completely cancel.

As for solutions [4] - [5] and [6], they appear strictly tied to the precise context in which the switch is inserted and, therefore, scarcely flexible and not easy to apply to different cases. Furthermore, in the topology disclosed in [4] and represented as an example in Figure 2c, it must be underlined that the partial immunity to clock-feedthrough is obtained at the cost of a doubling of the capacitors.

The use of non-ideal switches in the integrator, such as for instance the considered transistor MOS, leads to some linearity problems of the signal transferred at output (see [14] M. Marioni, "Convertitore Analogico/Digitale Sigma-Delta ad Altissima Frequenza in Tecnologia Silicio-Germanio" (Very High Frequency Sigma-Delta Analogue-to-Digital Converter in Silica-Germany Technology, Doctoral Thesis, University of Pavia, Academic Year 1998/1999). In fact, during the switching phase not all the amount of charge associated to the input signal is stored in the sampling capacitor $C_1$: as already said, this is a consequence of the fact that MOS switches show at their ends a non null equivalent resistance, even when the switch is closed (ON state).

As an example, consider the circuit of Figure 5 to examine in detail what happens during the phase $\Phi_1$ using one sole NMOS transistor to implement each switch. When phase $\Phi_1$ of the clock is active, the signal is loaded on the capacitor $C_1$ through two switches, each one having its own resistance $R_{ON}$. This occurs in a symmetrical manner on both the positive and negative branches of the differential circuits.

The drain-source conductance can also be calculated for the NMOS transistor $M_1$ reasonably assuming that it operates in triode region, in case $V_{in} < V_D$:

$$g_{ds} = \mu_N C_{ox}\frac{W}{L_{eff}}(V_{GD} - V_{th}) = \frac{1}{R_{ON}} \tag{6}$$

On the contrary, in case $V_{in} > V_D$ we have:

$$g_{ds} = \mu_N C_{ox}\frac{W}{L_{eff}}[V_G - V_{th} - (V_{cm} \pm V_s)] = \frac{1}{R_{ON}} \tag{7}$$

where $V_{in} = (V_{cm} + V_s)$, $V_s$ is the input signal and $V_{cm}$ is the common mode voltage value at input.

For PMOS transistors the same expressions can be obtained inverting the two cases, as it results evident to those skilled in the art.

The input signal charges the capacitor according to an exponential law, typical of RC circuits, whose time constant is function of the $R_{ON}$ and of the capacitor $C_1$, and the voltage on the capacitor increases with a finite derivate instead of instantly, as in the case of ideal switching.

As a consequence of this non-ideality it results that the actual voltage of the capacitor is only a fraction of the input signal $V_{in}$, that is, a voltage $\varepsilon$ is lost. Moreover, the loss is not linear: one of the two switches, through which $C_1$ is charged, does not have a constant $V_{GD}$ voltage during the whole phase $\Phi_1$, but a variable one. This involves also that the resistance of such switch will change from instant t=0 at instant t=T/2, thus varying also the charge time constant: the global effect shall be a non-linear signal loss and the introduction of harmonic distortion.

Also the differential structures do not guarantee the cancellation of non-linearity. The signal differential loss after a time $\Delta t$ shall be given by:

$$\left| \varepsilon_+ \right| - \left| \varepsilon_- \right| = V_S \cdot and^{-\Delta t / R_{ON} C_1} \cdot \left( and^{\frac{V_G - V_{TH} - V_{cm} - V_S}{V_G - V_{TH} - V_D}} - 1 \right) \tag{8}$$

From the previous formula it can be clearly noticed the dependence of the differential error on the input voltage contained in the exponential term in brackets, responsible for the non-linearity of the signal loss. It is evident that Equation (8) puts a severe limit on the maximum operating speed of the MOS switch.

This behaviour is additionally accentuated by the presence of *mismatches* between the positive and the negative path and makes the use of the CMOS switches difficult in the integrators for *sigma-delta* converters.

SCOPE AND SUMMARY OF THE INVENTION

Scope of the invention is to overcome the drawbacks and limits mentioned above, and in particular to implement switches which show higher performances in terms of speed and linearity compared to the previous techniques, without requiring the use of particular integration technologies, and are easy to use in analogue-to-digital converters *sigma-delta.*

A further object of the invention is a charge transfer network from a sampling capacitor to an integration capacitor including two identical structures consisting of two branches of switches in series between them. Said branches are connected in parallel between a first node and a second node, respectively connected to the supply nodes of the network through bias current generators.

The sampling capacitor is connected to a common current node (A) of the switches of the first branch of both the structures and the integration capacitor is connected to the first node of the first structure. The two structures share the current node (B) of the second branches.

The control signals of the switches of the first and second branch are cross coupled to two complementary control phases, $\Phi_1$ and $\Phi_2$, that is, each couple of branches having no first, second node, A and B nodes in common is controlled by the same control phase. The action of control phases alternatively assures the connection of a plate of the sampling capacitor $C_1$ to an analogue ground $V_A$ or to an integration capacitor $C_2$, performing the transfer of the stored charge towards the latter.

The charge transfer network can be made of bipolar transistors because they are immune of charge injection phenomena, less sensitive to the *clock-feedthrough* phenomenon, thanks to the reduces parasitic capacitances, and are intrinsically characterized by higher switching speed compared to the CMOS devices of the corresponding generation.

Using Si-Ge bipolar junction transistors it is also possible to obtain, at equal cost, faster switches or, at equal performance, lower implementation costs compared to switches made with MOS devices.

The charge transfer network can be conveniently employed to implement a switched-capacitors integrator having high operation frequency and analogue-to-digital converters *sigma-delta,* including the switched-capacitors integrator of the invention. The charge transfer network is used in the integrator to emulate the behaviour of the switches connecting a plate of the sampling capacitor $C_1$ to an analogue ground voltage or to the inverting input of the operational amplifier.

The *sigma-delta* converter of the invention is preferably equipped with a *switched-buffer* (see [15] C. Fiocchi, U. Gatti, F. Maloberti, "A 10 b 250 MHz BiCMOS track and hold", International Solid-State Circuits Conference, 1997, Digest of Technical Papers, page 144-145, 444 and [16] P. Vorenkamp, R. Roovers, "A 12 b 50 M sample/s cascaded folding and interpolating ADC, International Solid-State Circuits Conference, 1997, Digest of Technical Papers, page 134-135, 442), multi-input consisting of a tern of buffers coupled to a same number of level shifters.

Each buffer receives as input the input voltage $V_{in}$ of the converter, a reference voltage $V_R$ and its opposite $-V_R$, respectively. The level shifters are equipped with switches, controlled by the control phases in order that only one level shifter at a time is conducting, while the other two level shifters are in high impedance condition.

The multi-input *switched-buffer* is employed to connect the other plate of $C_1$ to signal $V_{in}$, to the reference voltage $+V_R$ or to its opposite $-V_R$ during phases $\Phi_1$, $\Phi_2$ and $\overline{\Phi_{out}}$ and $\Phi_2$ and $\Phi_{out}$, respectively.

The invention is defined more in detail in the appended claims.

BRIEF DESCRIPTION OF DRAWINGS

The present invention, together with further characteristics and advantages thereof, may be understood by those skilled in the art with reference to the following detailed description, taken in conjunction with the accompanying drawings, in which:

**Figure 1a** shows an ideal switch;
**Figure 1b** shows a MOS switch;
**Figure 2a** shows a CMOS switch
**Figure 2b** shows a MOS switch with *dummy-switch;*
**Figure 2c** shows a MOS switch with circuit for the compensation of the charge injected;
**Figure 3** shows the general diagram of an analogue-to-digital *sigma-delta* converter;
**Figure 4** shows the general diagram of a switched-capacitors integrator with ideal switches for an analogue-to-digital *sigma-delta* converter;
**Figure 5** shows the diagram for the calculation of the charge error in integrators implemented with MOS switches;
**Figure 6a** shows the general diagram of the charge transfer circuit with the ideal switches of the invention;
**Figure 6b** shows a preferred embodiment with bipolar junction transistors of the charge transfer device of Figure 6a;
**Figure 7** shows the diagram of an integrator for a switched-capacitors *sigma-delta* converter equipped with the charge transfer device of the invention;
**Figure 8** shows a preferred embodiment of a *triple switched-buffer* for a switched-capacitors *sigma-delta* converter of the invention.

DESCRIPTION OF SOME EMBODIMENTS OF THE INVENTION

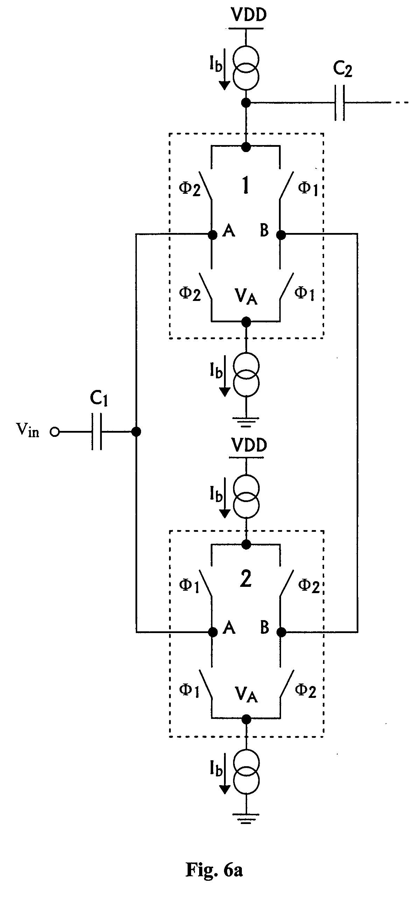

Figure 6a is an essential diagram of the charge transfer network of the invention from the sampling capacitor $C_1$ towards the integration capacitor $C_2$. The transfer network of the invention is essentially obtained connecting together two structures (1 and 2) consisting of the parallel of two branches, each of them consisting of two switches in series. The control signals of the switches are cross coupled to two control phases $\Phi_1$ and $\Phi_2$, in the sense that the control signal of both the switches of a same branch is connected to the control signal of the switches of the branch with which it doesn't share any node, as indicated in the figure.

During phase $\Phi_1$ the sampling capacitor $C_1$ is charged with a voltage equal to the difference between the input voltage and the analogue ground voltage $V_A$, while the integration capacitor $C_2$ has a node at the potential of node B, that is, $V_A$ if all is symmetric. As phase $\Phi_1$ disables, phase $\Phi_2$ enables, therefore the charge stored in the capacitor $C_1$ is transferred to capacitor $C_2$, while node B is still connected to the analogue ground voltage $V_A$.

In principle, the second branch of structure 2 can be eliminated since it does not affect neither the input signal sampling on $C_1$ nor the transfer of the charge from $C_1$ to $C_2$. However, its presence is essential to optimise the switching times, as it shall be clear in the description of the preferred embodiment.

Obviously, it can be managed that the second branch of structure 2 is always switched on. The choice to avail of the possibility to switch it from ON to OFF and vice versa through the control phase $\Phi_2$ has been essentially made to have a network behaviour as symmetric as possible. In this way, the inevitable errors in the charge transfer produced by the network will result in practice not to depend on the input signal.

To make the charge transfer perfectly symmetric and to prevent fluctuations in the voltage of node B, it is preferred to connect an auxiliary capacitor $C_3$, identical to the sampling capacitor $C_1$, between said common node B and the ground node.

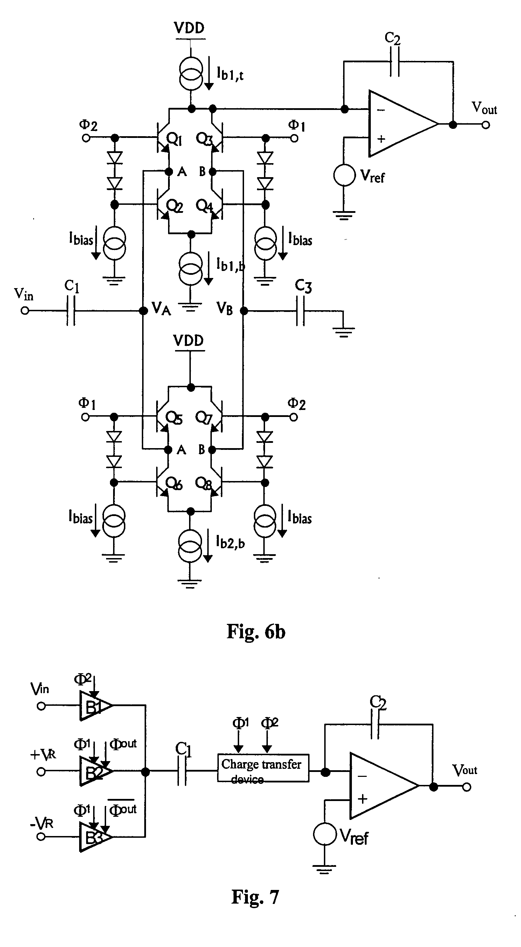

According to a preferred embodiment of the charge transfer network of the invention, in each structure 1 and 2, the two couples of switches belonging to different branches and having a current node in common are made of relevant switching circuits consisting of the two couples of bipolar transistors having the same conductivity type $Q_1$ - $Q_2$, $Q_3$ - $Q_4$, and $Q_5$ - $Q_6$, $Q_7$ - $Q_8$, in series among them. As shown in Figure 6b, the bases of the transistors of the first couples shall be cross-controlled by the complementary phases $\Phi_1$ and $\Phi_2$.

Since the bases of the transistors $Q_1$-$Q_2$, $Q_3$-$Q_4$, $Q_5$-$Q_6$, $Q_7$-$Q_8$ of each circuit are connected to a cascade of two diodes forward biased in series to a bias current generator, they simultaneously switch from saturation to interdiction and vice versa.

During phase $\Phi_1$ the branches formed by transistors $Q_3$-$Q_4$ and $Q_5$-$Q_6$ are active, resulting switched on in the so-called "saturation" operation region. The voltage drop between the collector and the emitter of these devices is relatively low (approx. 100 mV) and scarcely sensitive to the signal, therefore it can be considered as a constant offset.

Variations of the collector current $I_C$ turn into negligible variations of the $V_{CE}$, according to a linear proportionality. This last consideration indicates how the $R_{ON}$ of the bipolar transistors is in practice constant as $I_C$ varies and very low (some ohms only). This fact represents an advantage compared to MOS switches, enabling an increase in speed and linearity performances.

In this configuration, the capacitor $C_1$ has a plate connected to $V_{in}$ and the second one connected to a voltage $V_A$, determined by the bias conditions of $Q_5$, $Q_6$ and by the lower current generator $I_{b2,b}$. So the input signal $V_{in}$ is sampled on the capacitor $C_1$. Since the transistors $Q_1$-$Q_2$ and $Q_7$-$Q_8$ are switched off, the capacitor $C_2$ results isolated from $C_1$. Since a plate is connected to an analogue ground $V_B$ equal to $V_A$, the capacitor $C_2$ maintains the charge previously accumulated.

On the contrary, during phase $\Phi_2$ transistors $Q_1$-$Q_2$ and $Q_7$-$Q_8$ are turned on and $Q_3$-$Q_4$ and $Q_5$-$Q_6$ are turned off: the second plate of $C_1$ is connected to a terminal of $C_2$ and the charge stored on the capacitor $C_1$ is transferred to the capacitor $C_2$.

The switching on of the path formed by the transistors $Q_7$ and $Q_8$, during phase $\Phi_2$, is useful to keep the node B at fixed voltage $V_B=V_A$, preventing that transistors are put in a non desired operation region, thus optimising the switching time and the frequency performances of the circuit.

Contrarily to what can happen in the network of Figure 6a, it is not possible to maintain the node B at the analogue ground voltage $V_B=V_A$ always keeping transistors $Q_7$ and $Q_8$ conducted. In this case in fact, during the phase $\Phi_1$ in which also transistors $Q_3$ and $Q_4$ are active, the node B would be simultaneously polarized by two paths in parallel and its voltage would not have a voltage value that could not be accurately controlled in advance.

To implement the charge transfer network of Figure 6b, bipolar junction transistors of the NPN type could be conveniently employed, and diodes could be obtained by means of diode-connected NPN transistors.

The bias current generators $I_{b1,t}$ and $I_{b1,b}$ ideally have equal value, so that the current sourced $I_{b1,t}$ is equal to that flowing across $I_{b1,b}$. In a more realistic situation, the currents of the generators $I_{b1,t}$ and $I_{b1,b}$ shall not be equal, but it is possible to nullify this disadvantage through known feedback control circuits.

Referring to Figure 7, it is now described the detailed operation of the switched-capacitors integration stage of a *sigma-delta* converter.

During the phase $\Phi_1$ the *switched-buffer* B1 connects the input voltage $V_{in}$ to a plate of the capacitor $C_1$, while the charge transfer network connects the second plate of $C_1$ to the analogue ground $V_A$. Thanks to this configuration, the input voltage $V_{in}$ of the converter is sampled on $C_1$. At the same time, the integration capacitor $C_2$ is isolated from the input, *switched-buffers* B2 and B3 are put in high impedance and therefore do not interfere with the circuit operation.

During the phase $\Phi_2$ the *switched-buffer* B1 is placed in high impedance, so to isolate the input from $C_1$. On the contrary, only one of the *switched-buffers* B2 and B3 is active, depending on sub-phase $\Phi_{out}$, of phase $\Phi_2$, assuming active logic value only when the phase $\Phi_2$ is active.

If $\Phi_{out}$ is disabled, the buffer B2 is active while the buffers B3 and B1 are disabled. In this way, the voltage $+V_R$ is at the input of the switched-capacitors integrator. When $\Phi_{out}$ is active while $\Phi_2$ is active, only the buffer B3 is active, therefore the voltage $-V_R$ is present on the sampling node.

During the phase $\Phi_2$, the charge transfer network of the invention connects a plate of $C_1$ to the integration capacitor $C_2$ and enables the charge transfer between the two capacitors. In brief, compared to the description of the principle of an integration stage of Figure 4, the buffers B1, B2 and B3 replace the switches S1 and S2, while the charge transfer network replaces switches S3 and S4.

The charge transfer network of the invention enables to implement switched-capacitors integrators that can be integrated in analogue-to-digital *sigma-delta* converters capable of satisfying the SFDR requirement requested by GSM 900 MHz/DCS 1800 MHz and

UMTS specifications, which is included between 75 and 85 dBFS, conjugating at the same time high operation speed and input broad band.

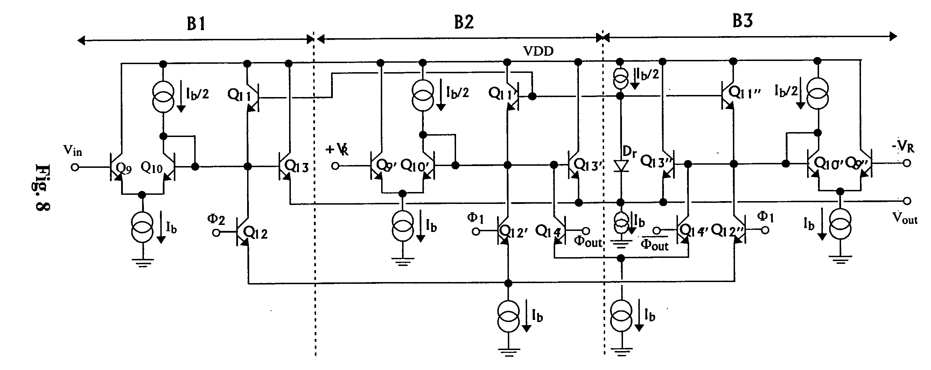

According to a preferred embodiment, a *sigma-delta* converter of the invention is provided with a multi-input *switched-buffer* as that shown in Figure 8, completely realized with bipolar junction transistors.

The *switched-buffer* of Figure 8 produces at output a voltage $V_{in}$ during phase $\Phi_1$ and a voltage $+V_R$ or $-V_R$ during phase $\Phi_2$, according to the enabled or disabled logic state of $\Phi_{out}$. It includes three input buffers, consisting of the differential couples of bipolar transistors $Q_9$-$Q_{10}$, $Q_9'$-$Q_{10}'$, $Q_9''$-$Q_{10}''$ and the relevant current generators, three level shifters (*"level-shifters"*) consisting of the transistors $Q_{13}$, $Q_{13}'$ and $Q_{13}''$ having the emitters connected together and of the relevant current generators, and of the transistors-switches controlled by the driving phases $\Phi_1$, $\Phi_2$ and of sub-phase $\Phi_{out}$.

The operation of the circuit of Figure 8 is similar to that of the known *switched-buffers* and shall be briefly described.

The complementary control phases $\Phi_2$ and $\Phi_1$ drive three main switches, $Q_{12}$, $Q_{12}'$ and $Q_{12}''$. During phase $\Phi_1$, the transistor $Q_{12}$ is switched off, while $Q_{12}'$ and $Q_{12}''$ are switched on. The voltage on the base of $Q_{13}$ represents a replica of the input signal $V_{in}$, obtained through the differential couple $Q_9$ and $Q_{10}$. The transistor $Q_{13}$ is switched on and the replica of the input voltage is transferred to the output node $V_{out}$ shifted by a voltage $V_{be}$. At the same time, considering that $Q_{12}'$ and $Q_{12}''$ are switched on, the voltage of the base of $Q_{13}'$ and $Q_{13}''$ are set at an opportune value ($V_{ref} - V_{be}$, through $Q_{11}'$ and $Q_{11}''$), which assures its switching off: in this operation condition, level shifters $Q_{13}'$ and $Q_{13}''$ show high output impedance and prevent that the voltage $+V_R$ or $-V_R$ is transferred on the converter output node.

During the phase $\Phi_2$ the transistor $Q_{12}$ is turned on, while $Q_{12}'$ and $Q_{12}''$ are turned off. The level shifter $Q_{13}$ is turned off and is in high impedance. Two additional switches, $Q_{14}'$ and $Q_{14}''$, keep $Q_{13}'$ or $Q_{13}''$ alternatively turned on according to the enabled or disabled state of sub-phase $\Phi_{out}$. Thanks to this timing, during the phase $\Phi_2$ the voltage $V_{out}$ will result equal to $+V_R$ or to $-V_R$.

In conclusion, the combined use of the charge transfer device and of the multiple input *switched-buffer* in analogue-to-digital *sigma-delta* converters represents an improvement compared to previous implementations, since it enables to increase the performance of these circuits in terms of speed maintaining or improving accuracy.

**Claims**

1. Charge transfer network from a sampling capacitor ($C_1$) to an integration capacitor ($C_2$), the sampling capacitor ($C_1$) showing the first plate connected to a supply source ($V_{in}$) and the second plate connected to the ground through at least one switch, the integration capacitor ($C_2$) being connected to the sampling capacitor ($C_1$) through at least one additional switch, **characterized in that** it consists of two identical structures (1 and 2) enclosing said switches and consisting of a first branch and of a second branch connected in parallel between a first node and a second node, respectively connected to the supply nodes through bias current generators, each branch consisting of a couple of switches in series, said sampling capacitor ($C_1$) being connected at a common current node (A) of the switches of said first branch of both the structures and said integration capacitor ($C_2$) being connected to said first node of the first structure, common current nodes (B) of the switches of said second branch of both the structures being connected between them, the control signals of the switches of said first and second branches being cross coupled to two control phases ($\Phi_1$, $\Phi_2$).

2. The charge transfer network of claim 1, includes also an auxiliary capacitor ($C_3$), equal to said sampling capacitor ($C_1$), connected between a ground node and said common current node (B) of the transistors of said second branch.

3. The charge transfer network according to one of claims 1 and 2, in which, in both said structures 1 and 2, in place of each couple of switches belonging to different branches and having a current node in common, is employed a switching circuit functionally equivalent, coupled between the supply nodes and made of couples ($Q_1$-$Q_2$, $Q_3$-$Q_4$; and $Q_5$-$Q_6$, $Q_7$-$Q_8$) of bipolar junction transistors having the same conductivity type in series, in which the bases of the transistors in series belonging to one or to the other couple, respectively ($Q_1$-$Q_2$, $Q_3$-$Q_4$, and $Q_5$-$Q_6$, $Q_7$-$Q_8$) are connected between them by a chain of forward biased diodes, and in turn in series to a bias current ($I_{BIAS}$) generator, said control phases ($\Phi_1$, $\Phi_2$) being respectively coupled to the base nodes of said transistors in series to which the anode of the first of said diodes in series is connected.

4. The charge transfer network of claim 3, in which said diodes are made of bipolar junction transistors connected in a diode configuration.

5. The charge transfer device according to any claim 1 to 4, in which said transistors are bipolar junction transistors NPN.

6. Switched-capacitors integrator including a sampling capacitor ($C_1$), a first plate of which can be switched on an input node of said integrator, an integration stage having an integration capacitor ($C_2$), a generator of first ($\Phi_1$) and second ($\Phi_2$) control phases in phase opposition between them, switching means of the second plate of said sampling capacitor ($C_1$) alternately to an input node of said input stage and to the ground, controlled by said control phases, **characterized in that** said switching means are made of a charge transfer network as defined in any claim 1 to 5.

7. Analogue-to-digital *sigma-delta* converter, including a switched-capacitors integrator according to claim 6 whose control phases generator produces a control sub-phase ($\Phi_{OUT}$) of said second phase ($\Phi_2$) and input buffer (B1, B2, B3) supplying said switched-capacitors integrator with an input voltage ($+V_{in}$) of said converter during said first phase ($\Phi_1$), a reference voltage ($V_R$) or its opposite ($-V_R$), respectively, according to the enabled or disabled logic state of said sub-phase ($\Phi_{OUT}$), during said second phase ($\Phi_2$).

8. The converter of claim 7, in which said input buffers consist of a multi-input circuit made of a tern of differential buffers ($Q_9$, $Q_{10}$; $Q'_9$, $Q'_{10}$; $Q''_9$, $Q''_{10}$), connected to relevant level shifters ($Q_{13}$; $Q'_{13}$; $Q''_{13}$), receiving at input said input voltage of the converter ($V_{in}$), said reference voltage ($+V_R$) and its opposite ($-V_R$), respectively, said level shifters ($Q_{13}$; $Q'_{13}$; $Q''_{13}$) being placed in interdiction at enabling of said first phase ($\Phi_1$), at disabling of said sub-phase ($\Phi_{OUT}$) and at enabling of said sub-phase ($\Phi_{OUT}$), respectively, while said second phase ($\Phi_2$) is active.

$\Phi_{ck}$

$V_{in}$ ⟶ 1 ⟶ 2 ⟶ $V_{out}$ ⟶ $Z_L$

**Fig. 1a**

$\Phi_{ck}$

G

$V_{in}$ S ⟶ D ⟶ $V_{out}$ ⟶ $Z_L$

**Fig. 1b**

**Fig. 2a**

**Fig. 2b**

**Fig. 2c**

SAMPLING DEVICE    INTEGRATOR    COMPARATOR    LATCH

$V_{in}$

$V_{out}$

$\Phi_{out}$

$+V_R$

$-V_R$

**Fig. 3**

$V_{in}$

$\Phi_1$

$S_1$

$C_1$

$\Phi_2$

$S_3$

$C_2$

$V_{out}$

$S_2 / \Phi_2$

$S_4 / \Phi_1$

$\pm V_R$

−

+

**Fig. 4**

$\Phi_1$

$G$

$C_1$

$V_{in}$

$S$

$M1$

$D$

$D$

$M2$

$\Phi_1$

$S$

**Fig. 5**

Fig. 6a

**Fig. 6b**

**Fig. 7**

Fig. 8